# FASCICULE DE BREVET EUROPEEN

(11) **EP 0 858 108 B1**
(45) Date de publication et mention de la délivrance du brevet: **01.12.2004**
(21) Numéro de dépôt: 98400273.3
(22) Date de dépôt: 09.02.1998
(51) Int. Cl.: H01L 25/10, H01L 25/065, H01L 21/98

(54) **Structure monobloc de composants empilés**
Monoblockstruktur mit gestapelten Bauelementen
Monoblock structure consisting of stacked components

(30) Priorité: 10.02.1997 FR 9701481
(43) Date de publication de la demande: 12.08.1998
(73) Titulaire: ALCATEL, 75008 Paris (FR)
(72) Inventeur: Drevon, Claude, 31500 Toulouse (FR)
(74) Mandataire: Smith, Bradford Lee

(56) Documents cités:
- FR-A- 2 688 629
- US-A- 3 746 934
- US-A- 5 291 061
- LARCOMBE S P ET AL: "UTILIZING A LOW COST 3D PACKAGING TECHNOLOGY FOR CONSUMER APPLICATIONS" 1 novembre 1995 , IEEE TRANSACTIONS ON CONSUMER ELECTRONICS, VOL. 41, NR. 4, PAGE(S) 1095 - 1101 XP000553486 * figures 3,7 *

## Description

La présente invention concerne de manière générale une structure monobloc compacte de composants empilés.

Il est connu selon la technique antérieure, par exemple décrite dans le US-A-5 101 323, un circuit multicouches qui est obtenu par moulage d'une pluralité de couches, ou niveaux, de composant dans un même bloc, typiquement parallélépipédique. Chaque couche de composants inclut au moins un composant et une piste établissant une connexion avec ledit composant et s'étendant vers l'un des côtés du bloc parallélépipédique. Des liaisons interniveaux, typiquement des pistes métallisées, sont formées sur les côtés du bloc parallélépipédique entre les composants de différents niveaux par gravure du bloc qui a été préalablement métallisé.

Une structure similaire a été décrite dans le document par S.P. Larcombe et al. "Utilizing a low cast 3D packaging technology for consumer applications", apparu dans IEEE Transactions on consumer electronics, Vol. 41, No. 4, pages 1095-1101, le 1. nov. 1995.

En raison de l'avantage que constitue l'utilisation d'un seul côté du bloc pour porter les points de connexion haute-fréquence ou basse fréquence d'entrée vers et/ou de sortie des composants, cette solution présente alors l'inconvénient d'obliger le contournement d'une arête du bloc par des pistes. Cela implique alors notamment une difficulté technique de gravure de la piste au niveau de l'arête, une plus grande fragilité de la gravure sur cette arête, etc...

L'invention vise à remédier à cet inconvénient en fournissant une structure monobloc de composants empilés qui ne requiert pas le contournement d'une arête par des pistes destinées à établir des liaisons entre des points de connexion d'entrée et/ou de sortie et les composants.

Un autre objectif de l'invention est de fournir un procédé de fabrication d'une telle structure monobloc.

A cette fin, une structure monobloc comprenant au moins deux niveaux de composant qui sont empilés, chaque niveau de composant comprenant:
- (1) une couche de matériau isolant formant un étage de composant et enrobant:
- (2) au moins un composant, et
- (3) au moins une première piste dont une première extrémité se connecte à un point de connexion dudit composant,
ladite structure comprenant, en outre, au moins une seconde piste disposée latéralement dont une première extrémité se connecte à une seconde extrémité de ladite première piste, est caractérisée selon l'invention en ce qu'elle comprend un moyen de circuit imprimé formant un étage de circuit imprimé et supportant au moins une troisième piste, une première extrémité de cette troisième piste étant couplée à un élément d'entrée et/ou sortie de signal dont une extrémité est apparente sur une face de ladite structure qui est parallèle auxdits étage de composant et étage de circuit imprimé, et une seconde extrémité de cette troisième piste étant connectée à une seconde extrémité de la seconde piste.

Selon une première variante, l'élément d'entrée et/ou sortie de signal est un élément de broche logé dans un trou métallisé du circuit imprimé.

Selon une autre variante, l'élément d'entrée et/ou sortie de signal est un élément de guide d'onde supportant au moins un picot de mise à la masse sur l'un de ses chants, le picot étant logé dans un trou métallisé du moyen de circuit imprimé qui forme une extrémité d'une piste de mise à la masse, et ladite première extrémité de la troisième piste étant couplée avec ledit guide d'onde.

Un procédé de fabrication d'une structure monobloc de composants empilés est également couvert par la présente invention. Le procédé comprend les étapes de:
(a) - empilement d'au moins deux niveaux de composant, chaque niveau de composant comprenant:
   - (1) une couche de matériau isolant formant un étage de composant et enrobant:
   - (2) au moins un composant, et
   - (3) au moins une première piste dont une première extrémité se connecte à un point de connexion dudit composant. Le procédé se caractérise en ce qu'il comprend les étapes suivantes:
(b) - moulage desdits au moins deux niveaux de composants empilés et d'un moyen de circuit imprimé appartenant à un étage de circuit imprimé et supportant au moins une troisième piste qui est couplée à un élément d'entrée et/ou sortie de signal, ledit élément d'entrée et/ou sortie de signal se dressant orthogonalement audit moyen de circuit imprimé, pour former une structure monobloc brute;
(c) - découpe de ladite structure monobloc brute pour faire apparaître une section dudit élément d'entrée et/ou sortie de signal et un chant de ladite troisième piste,
(d) - métallisation de la structure monobloc brute découpée résultante;
(e) - gravure d'au moins une seconde face de la structure monobloc brute découpée et métallisée pour former une seconde piste latérale entre une seconde extrémité de ladite première piste et une seconde extrémité de ladite troisième piste.

Pour la fabrication d'une structure à broche, le procédé comprend, en outre, les étapes de
(f) - gravure d'une première face de la structure monobloc brute découpée et métallisée sur laquelle apparaît la section dudit moyen de broche pour former une zone métallisée localisée au niveau de ladite section; et
(g) - croissance d'un bump sur ladite zone métallisée.

Typiquement, l'étape de croissance d'un bump sur la zone métallisée est une étape de croissance électrolytique.

D'autres caractéristiques et avantages de la présente invention apparaîtront plus clairement à la lecture de la description suivante, en référence aux dessins annexés correspondants, dans lesquels:
- la figure 1 montre une vue en coupe d'une structure monobloc brute de composants empilés selon l'invention;
- la figure 2 est une vue en perspective d'un circuit imprimé moulé dans la structure de la figure 1;
- la figure 3 est une vue de dessous de la structure monobloc brute de la figure 1, qui a été découpée et gravée;
- la figure 4 est une vue en coupe du module de la figure 1 en cours de fabrication; et
- la figure 5 montre une vue en perspective d'une variante de réalisation d'un élément d'entrée et/ou sortie de signal sous la forme d'un guide d'onde qui est intégré à la structure monobloc selon l'invention.

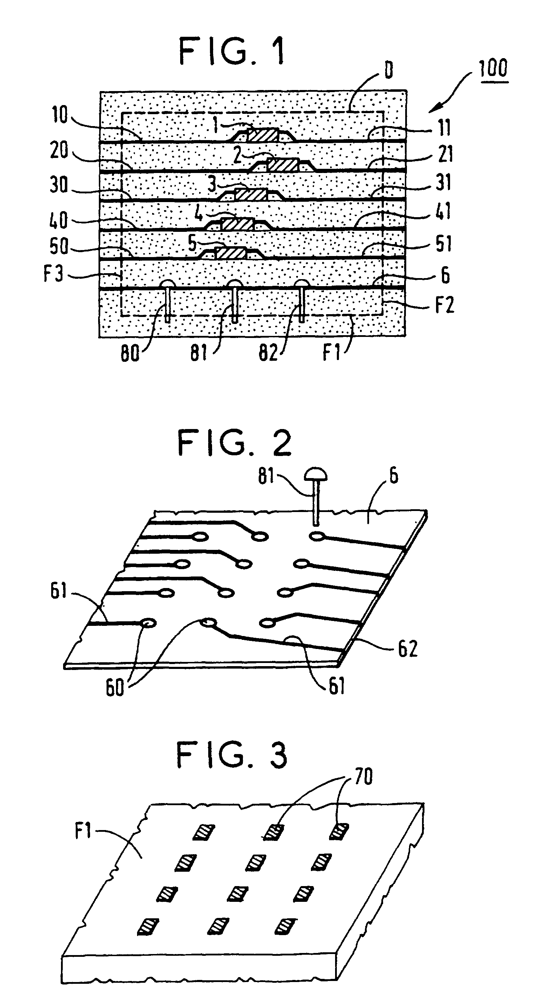

En référence à la figure 1, une structure monobloc brute 100 à partir de laquelle est formée une structure monobloc selon l'invention comprend au moins deux niveaux, ou étages, de composant qui sont empilés. Chaque niveau de composant comprend une couche de matériau isolant R, par exemple sous la forme d'une résine durcie enrobant, d'une part, au moins un composant 1, 2, 3, 4 ou 5 et, d'autre part, au moins une piste associée au composant du niveau considéré. A titre d'exemple, dans la figure 1, le composant 4 et les pistes 40 et 41 enrobés dans la résine R forment ensemble un niveau de composant. Pour chaque niveau de composant, l'une des deux extrémités de la piste 40 et 41 de cet étage se connecte à un point de connexion du composant 4. Par exemple, les composants 1, 2, 3, 4 et 5 des cinq niveaux représentés sont des composants hyperfréquences et les couples de pistes 10-11, 20-21, 30-31, 40-41 et 50-51 respectivement associés à ces composants sont des lignes coplanaires.

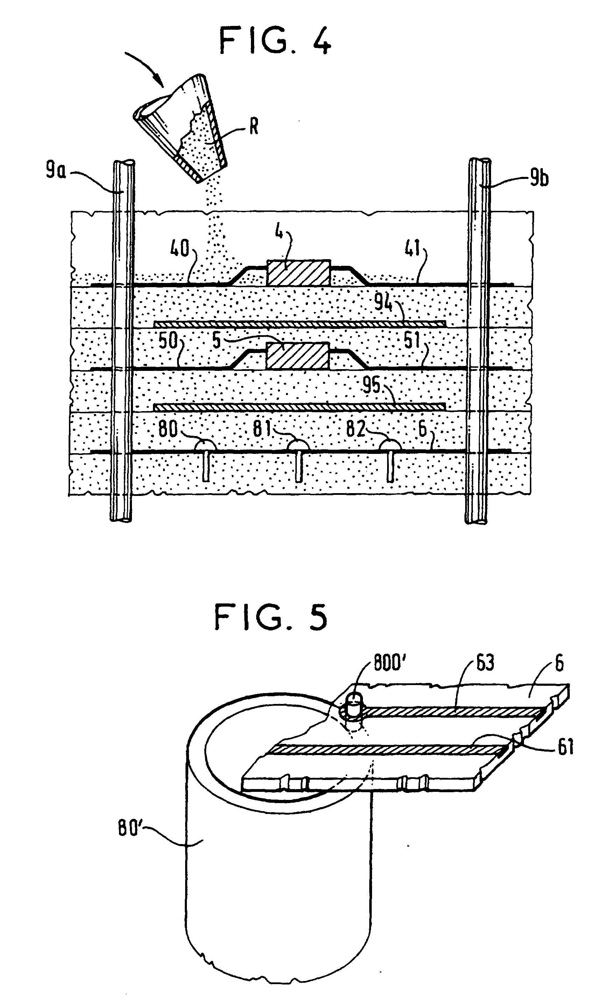

En référence aux figures 1 et 2, selon l'invention, il est prévu que cette structure monobloc brute 100, de laquelle résulte la structure selon l'invention, comprend, en outre, un étage de circuit imprimé incluant un circuit imprimé 6 enrobé dans de la résine. Ce circuit imprimé supporte au moins une piste de circuit imprimé 61, une première extrémité 60 de cette piste de circuit imprimé étant couplée à un élément d'entrée et/ou sortie de signal 80, 81 ou 82 dont une extrémité est apparente sur une face F1 de la structure qui est parallèle aux étages de composant et étage de circuit imprimé. Par exemple, l'élément d'entrée et/ou sortie de signal 80, 81 ou 82 est sous la forme d'une broche à tête logée et brasée dans un trou métallisé du circuit imprimé 6 qui est formé à l'extrémité de la piste 61. Il est à noter que d'autres réalisations peuvent être envisagées pour cet élément d'entrée et/ou sortie de signal 80, 81 ou 82 dont une extrémité est apparente sur une face F1 de la structure qui est parallèle aux étages de composant et étage de circuit imprimé. Selon la réalisation illustrée dans la figure 5, l'élément d'entrée et/ou sortie de signal est un guide d'onde 80' supportant par exemple au moins un picot de mise à la masse 800' sur l'un de ses chants. Le picot 800' se loge dans un trou métallisé d'une piste de mise à la masse 63 du circuit imprimé 6. Une piste 61 assure le couplage avec le guide d'onde. La piste 61 se prolonge au dessus du guide d'onde en étant séparé de celui-ci par le substrat du circuit imprimé 6.

En référence à la figure 4, il est maintenant présenté, à titre d'exemple un procédé de fabrication d'une structure monobloc brute telle que montrée dans la figure 1. Pour ce procédé, il est prévu un moule de forme parallélépipédique (non représenté) sur un fond obturé duquel se dresse des moyens de guidage, par exemple sous la forme de deux tiges allongées 9a et 9b. De la résine est introduite dans le fond du moule. Puis, le circuit imprimé 6 sur lequel se dresse orthogonalement chaque élément d'entrée/sortie de signal 80, 81, 82 ou 80' est placé, par guidage des deux tiges 9a et 9b, sur la surface de cette résine de fond, les éléments d'entrée et/ou sortie de signal pénétrant dans la résine non encore durcie. Puis successivement, par dépôts alternés de résine R et de plaques supportant les composants 5, 4 et les pistes associées 50-51, 40-41, la structure brute est formée. Après empilement du nombre souhaité d'étages de composant, l'on démoule la structure résultante qui se présente sous la forme d'un parallélépipède. Il peut être prévu, lors du moulage, d'insérer un plan de masse 95, 94 pour séparer deux étages de composant, notamment dans le cas où les composants sont des composants hyperfréquences, de sorte à éviter toute perturbation entre composants de deux étages adjacents.

Il est à noter que pour la variante selon laquelle chaque élément d'entrée et/ou sortie de signal est sous la forme d'une broche, chaque broche est introduite dans un trou métallisé 60 correspondant de la piste 61 du circuit imprimé 6 par l'une des faces du circuit imprimé tandis que pour la variante selon laquelle chaque élément d'entrée/sortie de signal est sous la forme d'un guide d'onde, chaque picot de mise à la masse 800' est introduit dans un trou métallisé correspondant de la piste 63 du circuit imprimé 6 par l'autre face du circuit imprimé. Pour cette seconde variante, la disposition des pistes de mise à la masse 63 et des piste de couplage 61 est telle qu'elle soit adaptée à la géométrie du guide d'onde 80'.

La structure brute de la figure 1 subit ensuite la transformation suivante. Tout d'abord, elle est découpée selon les traits discontinus D montrés dans la figure 1 pour faire apparaître, d'une part, les sections respectives des éléments d'entrée et/ou sortie de signal 80, 81, 82 ou 80' sur la face F1 et, d'autre part, des chants des pistes 10-11, 20-21, 30-31, 40-41 et 50-51 de chaque niveau de composant et des chants 62 des pistes 61 du circuit imprimé 6 sur des faces latérales F2, F3.

Après cela, dans la variante par guide d'onde, les faces latérales F2 et F3 sur lesquelles apparaissent les chants des pistes 10-11, 20-21, 30-31, 40-41 et 50-51 de chaque niveau de composant d'une part, et les chants 62 des pistes 61 du circuit imprimé 6 d'autre part, sont métallisées. Puis, ces faces sur lesquelles apparaissent, avant métallisation, les chants 62 des pistes 61 du circuit imprimé 6 sont gravées pour former chaque piste de liaison entre chacun de ces chants 62 et une extrémité d'une piste 10, 11, 20, 21, 30, 31, 40, 41, 50, 51 d'un étage de composant ainsi que chaque piste de liaison latérale entre les pistes 10, 20, 30, 40 et 50 et entre les pistes 11, 21, 31, 41 et 51. Cette étape de gravure consiste, par exemple, en une attaque laser de la couche métallisée uniforme de la face considérée F2 ou F3.

Dans le cas de la variante par broche, la structure brute découpée résultante est métallisée dans sa totalité par dépôt d'une couche métallisée sur sa surface. Puis, comme montré dans la figure 3, la face F1 sur laquelle apparaissaient, avant métallisation, les sections des éléments de broche 80, 81 et 82 est gravée pour former une zone métallisée 70 en contact avec chacune des sections d'élément de broche. Pour chacune de ces zones métallisées 70, une croissance de bump est réalisée, par exemple par croissance électrolytique. Il est à noter que ces zones 70 sont toutes connectées électriquement entr'elles à travers les pistes 61 du circuit imprimé 6 et les faces métallisées de la structure brute découpée et métallisée.

Ensuite, les faces F2 et F3 sur lesquelles apparaissent, avant métallisation, les chants 62 des pistes 61 du circuit imprimé 6 sont gravées pour former chaque piste de liaison entre chacun de ces chants 62 et une extrémité d'une piste 10, 11, 20, 21, 30, 31, 40, 41, 50, 51 d'un étage de composant, ainsi que chaque piste de liaison latérale entre les pistes 10, 20, 30, 40 et 50 et entre les pistes 11, 21, 31, 41 et 51. Cette étape de gravure consiste par exemple en une attaque laser de la couche métallisée uniforme de la face considérée.

## Revendications

1. Structure monobloc comprenant au moins deux niveaux de composant qui sont empilés, chaque niveau de composant comprenant:
- (1) une couche de matériau isolant (R) formant un étage de composant et enrobant:
- (2) au moins un composant (1, 2, 3, 4, 5), et
- (3) au moins une première piste (10-11, 20-21, 30-31, 40-41, 50-51) dont une première extrémité se connecte à un point de connexion dudit composant,
ladite structure comprenant, en outre, au moins une seconde piste disposée latéralement (F3, F2) dont une première extrémité se connecte à une seconde extrémité de ladite première piste (10-11, 20-21, 30-31, 40-41, 50-51);
**caractérisée en ce qu**'elle comprend un moyen de circuit imprimé enrobé (6) formant un étage de circuit imprimé et supportant au moins une troisième piste (61), une première extrémité (60) de cette troisième piste étant couplée à un élément d'entrée et/ou de sortie de signal (80, 81, 82) dont une extrémité est apparente sur une face de ladite structure qui est parallèle auxdits étage de composant et étage de circuit imprimé, et une seconde extrémité (62) de cette troisième piste étant connectée à une seconde extrémité de la seconde piste.

2. Structure conforme à la revendication 1, **caractérisée en ce que** ledit élément d'entrée et/ou sortie de signal (80, 81, 82) est un élément de broche logé dans un trou métallisé du circuit imprimé.

3. Structure conforme à la revendication 1, **caratérisée en ce que** ledit élément d'entrée et/ou sortie de signal (80, 81, 82) est un élément de guide d'onde supportant au moins un picot de mise à la masse sur l'un de ses chants, ledit picot étant logé dans un trou métallisé du moyen de circuit imprimé qui forme une extrémité d'une piste de mise à la masse, et ladite première extrémité (60) de la troisième piste (61) étant couplée avec ledit guide d'onde.

4. Procédé de fabrication d'une structure monobloc de composants empilés comprenant les étapes de:
(a) - empilement d'au moins deux niveaux de composant, chaque niveau de composant comprenant:
- (1) une couche de matériau isolant (R) formant un étage de composant et enrobant:
- (2) au moins un composant (1, 2, 3, 4, 5), et
- (3) au moins une première piste (10-11, 20-21, 30-31, 40-41, 50-51) dont une première extrémité se connecte à un point de connexion dudit composant;
(b) - moulage desdits au moins deux niveaux de composants empilés et d'un moyen de circuit imprimé (6) appartenant à un étage de circuit imprimé et supportant au moins une troisième piste qui est couplée à un élément d'entrée et/ou sortie de signal (80, 81, 82; 80'), ledit élément d'entrée et/ou sortie de signal (80, 81, 82; 80') se dressant orthogonalement audit moyen de circuit imprimé, pour former une structure monobloc brute;
(c) - découpe (D) de ladite structure monobloc brute pour faire apparaître une section dudit élément d'entrée et/ou sortie de signal (80, 81, 82; 80') et un chant (62) de ladite troisième piste (61),
(d) - métallisation de la structure monobloc brute découpée résultante;
(e) - gravure d'au moins une seconde face de la structure monobloc brute découpée et métallisée pour former une seconde piste latérale entre une seconde extrémité de ladite première piste et une seconde extrémité de ladite troisième piste.

5. Procédé conforme à la revendication 4 pour la fabrication d'une structure selon la revendication 2, **caractérisé en ce qu'**il comprend, en outre, les étapes de
(f) - gravure d'une première face de la structure monobloc brute découpée et métallisée sur laquelle apparaît la section dudit moyen de broche pour former une zone métallisée (70) localisée au niveau de ladite section; et
(g) - croissance d'un bump sur ladite zone métallisée.

6. Procédé conforme à la revendication 5, **caractérisé en ce que** l'étape de croissance d'un bump sur ladite zone métallisée est une étape de croissance électrolytique.

## Claims

1. A monobloc structure comprising at least two stacked component levels, each component level comprising:
- (1) a layer of insulative material (R) forming a component and encapsulation storey,
- (2) at least one component (1, 2, 3, 4, 5), and
- (3) at least a first track (10-11, 20-21, 30-31, 40-41, 50-51) a first end of which is connected to a connection point of said component,
said structure further comprising at least one second track disposed laterally (F3, F2) and a first end of which is connected to a second end of said first track (10-11, 20-21, 30-31, 40-41, 50-51); **characterized in that** it comprises a printed circuit means (6) forming a printed circuit storey and carrying at least one third track (61), a first end (60) of this third track being coupled to a signal input and/or output member (80, 81, 82) one end of which is exposed on a face of said structure parallel to said component and printed circuit storeys and a second end (62) of this third track being connected to a second end of the second track.

2. A structure according to claim 1 **characterized in that** said signal input and/or output member (80, 81, 82) is a pin member housed in a metallized hole in the printed circuit.

3. A structure according to claim 1 **characterized in that** said signal input and/or output member (80, 81, 82) is a waveguide member carrying at least one grounding pin on one of its edges, said pin being housed in a metallized hole in the printed circuit means that forms one end of a grounding track and said first end (60) of the third track (61) being coupled to said waveguide.

4. A process for fabricating a monobloc stacked component structure comprising the steps of:
(a) - stacking at least two component levels, each component level comprising:
- (1) a layer of insulative material (R) forming a component and encapsulation storey,
- (2) at least one component (1, 2, 3, 4, 5), and
- (3) at least one first track (10-11, 20-21, 30-31, 40-41, 50-51) a first end of which is connected to a connection point of said component,
(b) - moulding said at least two stacked component levels and a printed circuit means (6) forming part of a printed circuit storey and supporting at least one third track that is coupled to a signal input and/or output member (80, 81, 82; 80'), said signal input and/or output member (80, 81, 82; 80') upstanding orthogonally to said printed circuit means to form a monobloc structure preform,
(c) - cutting (D) said monobloc structure preform to expose a section of said signal input and/or output member (80, 81, 82; 80') and an edge (62) of said third track (61),
(d) - metallizing the resulting cut monobloc structure preform,
(e) - etching at least a second face of the metallized cut monobloc structure preform to form a second lateral track between a second end of said first track and a second end of said third track.

5. A process according to claim 4 for fabricating a structure according to claim 2 **characterized in that** it further comprises the steps of
(f) - etching a first face of the metallized cut monobloc structure preform on which the section of said pin means is exposed to form a metallized area (70) localized in said section, and
(g) - growing a bump on said metallized area.

6. A process according to claim 5 **characterized in that** the step of growing a bump on said metallized area is an electrolytic growth step.

## Patentansprüche

1. Monoblockstruktur, bestehend aus mindestens zwei Bauelementebenen, die gestapelt sind, wobei jede Bauelementebene Folgendes umfasst:
- (1) eine Schicht aus Isoliermaterial (R), die eine Bauelementebene bildet und in die Folgendes eingebettet ist:
- (2) mindestens ein Bauelement (1, 2, 3, 4, 5), und
- (3) mindestens eine erste Bahn (10-11, 20-21, 30-31, 40-41, 50-51), deren erstes Ende mit einem Anschlusspunkt des genannten Bauelements verbunden ist,
wobei die genannte Struktur außerdem mindestens eine zweite Bahn beinhaltet, die seitlich angeordnet ist (F3, F2), deren erstes Ende mit einem zweiten Ende der genannten ersten Bahn (10-11, 20-21, 30-31, 40-41, 50-51) verbunden ist;
**dadurch gekennzeichnet, dass** sie ein Mittel für eine eingebettete gedruckte Schaltung (6) beinhaltet, die eine Ebene der gedruckten Schaltung bildet und mindestens eine dritte Bahn (61) umfasst, wobei ein erstes Ende (60) dieser dritten Bahn mit einem Signaleingangs- und/oder Ausgangselement (80, 81, 82) gekoppelt ist, dessen Ende auf einer Seite der genannten Struktur sichtbar ist, die parallel zu der genannten Bauelementebene und der Ebene der gedruckten Schaltung verläuft, und wobei ein zweites Ende (62) dieser dritten Bahn mit einem zweiten Ende der zweiten Bahn verbunden ist.

2. Struktur gemäß Anspruch 1, **dadurch gekennzeichnet, dass** es sich bei dem genannten Signaleingangs- und/oder Ausgangselement (80, 81, 82) um ein Pin-Element handelt, das in einem mit Metall bedampften Loch der gedruckten Schaltung angeordnet ist.

3. Struktur gemäß Anspruch 1, **dadurch gekennzeichnet, dass** es sich bei dem genannten Signaleingangs- und/oder Ausgangselement (80, 81, 82) um ein Wellenleiterelement handelt, das an einer seiner Kanten mindestens einen Erdungsstift beinhaltet, wobei der genannte Stift in einem mit Metall bedampften Loch in dem Mittel für die gedruckte Schaltung angeordnet ist, das ein Ende einer Erdungsbahn bildet, und wobei das genannte erste Ende (60) der dritten Bahn (61) mit dem genannten Wellenleiter gekoppelt ist.

4. Herstellungsverfahren einer Monoblockstruktur mit gestapelten Bauelementen, bestehend aus folgenden Schritten:
(a) Stapeln von mindestens zwei Bauelementebenen, wobei jede Bauelementebene Folgendes umfasst :
- (1) eine Schicht aus Isoliermaterial (R) , die eine Bauelementebene bildet und in die Folgendes eingebettet ist:
- (2) mindestens ein Bauelement (1, 2, 3, 4, 5), und
- (3) mindestens eine erste Bahn (10-11, 20-21, 30-31, 40-41, 50-51), deren erstes Ende mit einem Anschlusspunkt des genannten Bauelements verbunden ist;
(b) - Gießen der genannten, mindestens zwei gestapelten Bauelementebenen sowie eines Mittels für eine gedruckte Schaltung (6), das zu einer Ebene der gedruckten Schaltung gehört und mindestens eine dritte Bahn umfasst, die mit einem Signaleingangsund /oder Ausgangselement (80, 81, 82; 80') gekoppelt ist, wobei das genannte Signaleingangs- und/oder Ausgangselement (80, 81, 82; 80') senkrecht zu dem genannten Mittel für eine gedruckte Schaltung angeordnet ist, um eine unbearbeitete Monoblockstruktur zu bilden;
(c) - Zuschnitt (D) der genannten, unbearbeiteten Monoblockstruktur, um einen Abschnitt des genannten Signaleingangsund/oder Ausgangselements (80, 81, 82; 80') sowie eine Kante (62) der genannten dritten Bahn (61) sichtbar zu machen;
(d) - Metallbedampfung der beim Zuschnitt entstandenen unbearbeiteten Monoblockstruktur;
(e) - Ätzen mindestens einer zweiten Seite der unbearbeiteten, zugeschnittenen und mit Metall bedampften Monoblockstruktur, um eine zweite seitliche Bahn zwischen einem zweiten Ende der genannten ersten Bahn und einem zweiten Ende der genannten dritten Bahn zu bilden.

5. Verfahren gemäß Anspruch 4 zur Herstellung einer Struktur gemäß Anspruch 2, **dadurch gekennzeichnet, dass** sie außerdem die folgenden Schritte umfasst:
(f) Ätzen einer ersten Seite der unbearbeiteten, zugeschnittenen und mit Metall bedampften Monoblockstruktur, auf der der Abschnitt der genannten Pin-Vorrichtung sichtbar ist, um eine mit Metall bedampfte Zone (70) zu bilden, die im Bereich des genannten Abschnitts angeordnet ist; und
(g) - Wachstum eines Löthöckers auf der genannten, mit Metall bedampften Zone.

6. Verfahren gemäß Anspruch 6, **dadurch gekennzeichnet, dass** es sich bei dem Schritt zum Löthöcker-Wachstum in der genannten, mit Metall bedampften Zone um einen Schritt mit elektrolytischem Wachstum handelt.
